# EUROPEAN PATENT APPLICATION

(11) **EP 1 677 316 A1**
(43) Date of publication of application: **05.07.2006**
(21) Application number: 04792740.5
(22) Date of filing: 21.10.2004
(51) Int. Cl.: H01B 5/14, H01M 14/00, H01L 31/04

(54) **TRANSPARENT CONDUCTIVE SUBSTRATE, ELECTRODE FOR DYE-SENSITIZED SOLAR CELL AND DYE-SENSITIZED SOLAR CELL**

(30) Priority: 23.10.2003 JP 2003363530; 30.10.2003 JP 2003370741; 30.10.2003 JP 2003370742
(71) Applicant: Bridgestone Corporation, Tokyo 104-8340 (JP)
(72) Inventor: OHNO, Shingo, c/o Bridgestone Corporation, Kodaira-shi, Tokyo 187-0031 (JP); IWABUCHI, Yoshinori, c/o Bridgestone Corporation, Kodaira-shi, Tokyo 187-0031 (JP); KOTSUBO, Hidefumi, c/o Bridgestone Corporation, Kodaira-shi, Tokyo 187-0031 (JP); MORIMURA, Yasuhiro, c/o Bridgestone Corporation, Kodaira-shi, Tokyo 187-0031 (JP); SUGI, Shinichiro, c/o BridgestoneCorporation, Kodaira-shi, Tokyo 187-0031 (JP); SUGIYAMA, Hideo, c/o Bridgestone Corporation, Kodaira-shi, Tokyo 187-0031 (JP); YOSHIKAWA, Masato, c/o Bridgestone Corporation, Kodaira-shi, Tokyo 187-0031 (JP)
(74) Representative: Whalley, Kevin
(86) International application number: PCT/JP2004/015590
(87) International publication number: WO 2005/041216

(57) **Abstract**

An acid-resistant transparent electroconductive substrate with an ITO layer includes a transparent base and the ITO layer formed over the transparent base. The ITO layer contains at least 30 percent by weight of tin oxide. A dye-sensitized solar cell electrode includes the transparent electroconductive substrate and a dye-adsorbed semiconductor layer formed over the ITO layer of the transparent electroconductive substrate. A dye-sensitized solar cell is provided which uses the dye-sensitized solar cell electrode as a dye-sensitized semiconductor electrode. A SnO₂ content of 30 percent by weight or more enhances acid resistance. The dye-sensitized semiconductor electrode for the dye-sensitized solar cell is prepared by forming a layer-by-layer self-assembled film on the ITO layer by a layer-by-layer assembly technique, forming a replica layer by acid-treating the layer-by-layer self-assembled film to form irregularities, and forming a semiconductor layer on the replica layer.

## Description

### Technical Field

The present invention relates to a transparent electroconductive substrate having such a high acid-resistance as is sufficient for applications requiring high acid resistance, and to a dye-sensitized solar cell electrode and a dye-sensitized solar cell that include the transparent electroconductive substrate.

The present invention relates to a transparent electroconductive body suitable for a transparent electrode disposed on the lower side of a semiconductor electrode and for an opposing electrode that is opposed to a dye-sensitized semiconductor electrode with an electrolyte in between, to a dye-sensitized solar cell electrode using the transparent electroconductive body, and to a dye-sensitized solar cell including the dye-sensitized solar cell electrode as the opposing electrode.

### Background of the Invention

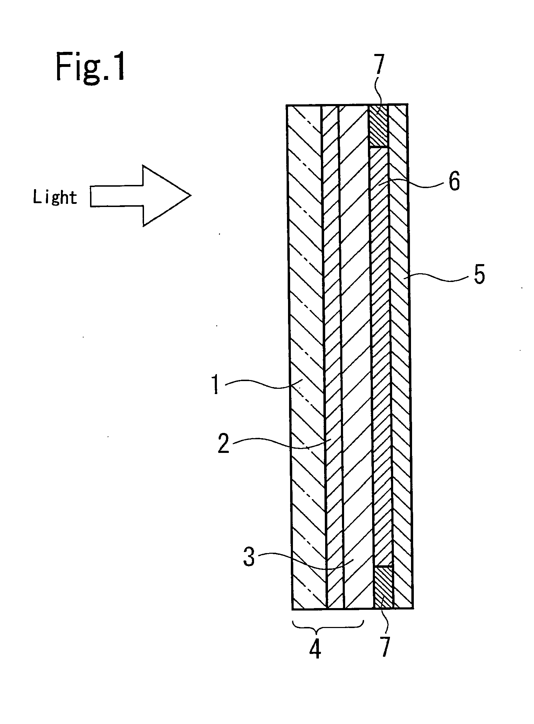

It has been known that a solar cell includes an electrode made of an oxide semiconductor that has adsorbed a sensitizing dye. Fig. 1 is a sectional view of the general structure of such a dye-sensitized solar cell. As shown in Fig. 1, a dye-sensitized semiconductor electrode 4 includes a substrate 1, such as a glass substrate, a transparent electroconductive layer 2 made of FTO (fluorine-doped tin oxide), ITO (indium tin oxide), or the like overlying the substrate 1, and a metal oxide semiconductor layer (dye-adsorbed semiconductor layer) 3 overlying the transparent electroconductive layer 2 and to which a spectral sensitizing dye has been adsorbed. The dye-sensitized semiconductor electrode 4 is opposed to an opposing electrode 5 at a distance, and an electrolyte 6 is sealed between the dye-sensitized semiconductor electrode 4 and the opposing electrode 5 with a sealant, which is not shown in the figure. Reference numeral 7 represents insulative spacers provided in the outer region for holding the distance between the semiconductor electrode 4 and the opposing electrode 5.

The dye-adsorbed semiconductor layer 3 is generally a titanium oxide thin layer that has adsorbed a dye. The titanium oxide thin layer is formed in a sol-gel process. The dye adsorbed to the titanium oxide thin layer is excited by visible light to generate electrons. The electrons are transferred to the particles of the titanium oxide, thereby generating electric power. The opposing electrode 5 is provided over the transparent electroconductive layer of, for example, ITO or FTO on the substrate of, for example, glass or plastic, and is formed of platinum or carbon acting as a catalyst for promoting the electron exchange between the transparent electroconductive layer and the sensitizing dye at a thickness that does not reduce the transmittance. The electrolyte 6 contains an oxidation-reduction material. For example, the oxidation-reduction material may be prepared by a combination of a metal iodide, such as LiI, NaI, KI, or CaI₂, and iodine, or a combination of metal bromide, such as LiBr, NaBr, KBr, or CaBr₂, and bromine. Preferably, the electrolyte 6 is prepared by dissolving an oxidation-reduction material containing a metal iodide and iodine in a solvent, such as propylene carbonate or other carbonates, or acetonitrile or other nitrile compounds.

In order for the dye-sensitized solar cell to exhibit a high power generation efficiency and stable characteristics, the titanium oxide layer of the dye-adsorbed semiconductor layer 3 needs to have so high a specific surface and be so porous as to adsorb dyes sufficiently. The titanium oxide layer is conventionally formed by a sol-gel process. The sol-gel process requires that the substrate 1 has such a high heat resistance as glass has, and does not allow the use of, for example, thermally unstable polymer films. This is why a flexible, lightweight and thin dye-sensitized solar cell is difficult to achieve.

Polymer films are thermally unstable, and accordingly it is unsuitable to form an FTO layer on the polymer films by CVD (chemical vapor deposition). Indium oxide-based materials, such as ITO, have lower acid resistances than tin oxide-based materials, such as FTO.

If a metal or alloy layer having a lower resistance than metal oxide layers, such as ITO, is formed as the opposing electrode or the transparent electroconductive layer overlying the substrate of the semiconductor electrode in the dye-sensitized solar cell, the metal or alloy layer is corroded by iodine or other constituents in the electrolyte. Therefore such a metal or alloy layer cannot be formed. Accordingly, the opposing electrode and the transparent electroconductive layer of the semiconductor electrode are conventionally formed of metal oxides, such as ITO. However, the resistances of metal oxide transparent electroconductive layers are not sufficiently low. This is a cause of low photoelectric conversion efficiency of the dye-sensitized solar cell.

### Summary of the Invention

First to third aspects of the present invention are intended to provide a transparent electroconductive substrate including an ITO layer and having such a high acid resistance as is sufficient for applications requiring high acid resistance, and a dye-sensitized solar cell electrode and a dye-sensitized solar cell that include the transparent electroconductive substrate.

An acid-resistant transparent electroconductive substrate according to the first aspect includes a transparent base and an ITO layer formed on the transparent base. In the transparent electroconductive substrate, the ITO layer contains at least 30 percent by weight of tin oxide.

A dye-sensitized solar cell electrode according to the second aspect includes the transparent electroconductive substrate of the first aspect and a dye-adsorbed semiconductor layer formed on the ITO layer of the transparent electroconductive substrate. By using a polymer film as the base, the dye-sensitized solar cell electrode can be flexible.

The acid-resistant transparent electroconductive substrate of the first aspect is highly resistant to acids and significantly useful for applications requiring acid resistance. The acid-resistant transparent electroconductive substrate used in the second aspect is advantageous in preparing a dye-sensitized semiconductor electrode for a dye-sensitized solar cell by forming a layer-by-layer self-assembled film on the ITO layer by a layer-by-layer assembly technique, forming a replica layer by acid-treating the layer-by-layer self-assembled film to form irregularities, and forming a semiconductor layer on the replica layer.

A dye-sensitized solar cell according to the third aspect includes a dye-sensitized semiconductor electrode, an opposing electrode opposing the dye-sensitized semiconductor electrode, and an electrolyte disposed between the dye-sensitized semiconductor electrode and the opposing electrode. In the dye-sensitized solar cell, the dye-sensitized semiconductor electrode is the dye-sensitized solar cell electrode of the second aspect.

Fourth to sixth aspects of the present invention are also intended to provide a transparent electroconductive substrate having such a high acid resistance as is sufficient for applications requiring high acid resistance, and a dye-sensitized solar cell electrode and a dye-sensitized solar cell that include the transparent electroconductive substrate.

An acid-resistant transparent electroconductive substrate according to the fourth aspect includes a transparent base and a transparent electroconductive layer formed on the transparent base. In the transparent electroconductive substrate, a titanium oxide thin layer is formed on the transparent electroconductive layer.

The acid-resistant transparent electroconductive substrate of the fourth aspect is suitable for a dye-sensitized solar cell electrode according to the fifth aspect.

The dye-sensitized solar cell electrode of the fifth aspect includes the transparent electroconductive substrate of the fourth aspect and a dye-adsorbed semiconductor layer formed on the titanium oxide thin layer of the transparent electroconductive substrate. By using a polymer film as the base, the dye-sensitized solar cell electrode can be flexible.

The acid-resistant transparent electroconductive substrate of the fourth aspect is superior in acid resistance and significantly useful for applications requiring acid resistance. The acid-resistant transparent electroconductive substrate used in the fifth aspect is advantageous in preparing a dye-sensitized semiconductor electrode for a dye-sensitized solar cell by forming a layer-by-layer self-assembled film on the transparent electroconductive layer, such as an ITO layer, by a layer-by-layer assembly technique, forming a replica layer by acid-treating the layer-by-layer self-assembled film to form irregularities, and forming a semiconductor layer on the replica layer.

A dye-sensitized solar cell according to the sixth aspect includes a dye-sensitized semiconductor electrode, an opposing electrode opposing the dye-sensitized semiconductor electrode, and an electrolyte disposed between the dye-sensitized semiconductor electrode and the opposing electrode. In the dye-sensitized solar cell, the above-described dye-sensitized solar cell electrode of the present aspect is used as the dye-sensitized semiconductor electrode.

Seventh to ninth aspects of the present invention are intended to provide a transparent electroconductive body useful for a dye-sensitized solar cell electrode. The transparent electroconductive body has a sufficiently low resistance, is not corroded by electrolytes, and is effective in increasing the photoelectric conversion efficiency of dye-sensitized solar cells. Seventh to ninth aspects are also intended to provide a dye-sensitized solar cell electrode including the transparent electroconductive body, and a dye-sensitized solar cell including the electrode.

A transparent electroconductive body according to the seventh aspect includes a base and a transparent electroconductive layer overlying the base. In the transparent electroconductive body, a meshed electrical conductor is provided between the base and the transparent electroconductive layer. The electrical conductor is made of a metal or alloy having a lower resistance than the transparent electroconductive layer. The meshed electrical conductor is formed through the first step of forming dots of a material soluble in a solvent on the surface of the base, the second step of forming an electroconductive material layer of an electroconductive material insoluble in the solvent over the surface of the base, and the third step of removing the dots and the electroconductive material layer in the regions overlying the dots by bringing the surface of the base into contact with the solvent.

A dye-sensitized solar cell electrode according to the eighth aspect includes the transparent electroconductive body of the seventh aspect.

A dye-sensitized solar cell according to the ninth aspect includes a dye-sensitized semiconductor electrode, an opposing electrode opposing the dye-sensitized semiconductor electrode, and an electrolyte disposed between the dye-sensitized semiconductor electrode and the opposing electrode. In the dye-sensitized solar cell, the opposing electrode is the electrode as set forth in Claim 22.

### Brief Description of the Drawings

[Fig. 1] Fig. 1 is a sectional view of the general structure of a dye-sensitized solar cell.
[Fig. 2] Figs. 2a to 2d are schematic sectional views of a process for forming a semiconductor layer of a prior application.
[Fig. 3] Fig. 3 is a schematic sectional view of a semiconductor layer formed by the process shown in Figs. 2a to 2d.
[Fig. 4] Fig. 4 is a schematic sectional view of a semiconductor layer formed by the process shown in Figs. 2a to 2d.
[Fig. 5] Fig. 5 is a schematic sectional view of a semiconductor layer formed by the process shown in Figs. 2a to 2d.
[Fig. 6] Fig. 6 is a perspective view of an opposing electrode for a dye-sensitized solar cell according to an embodiment of the eighth aspect.
[Fig. 7] Fig. 7 is a sectional view of a dye-sensitized solar cell electrode according to another embodiment.
[Fig. 8] Fig. 8 is a schematic sectional view of a step in a process for forming a meshed electrical conductor according to the seventh aspect.
[Fig. 9] Fig. 9 is a schematic sectional view of a step in the process for forming the meshed electrical conductor according to the seventh aspect.
[Fig. 10] Fig. 10 is a schematic sectional view of a step in the process for forming the meshed electrical conductor according to the seventh aspect.
[Fig. 11] Fig. 11 is a schematic sectional view of a step in the process for forming the meshed electrical conductor according to the seventh aspect.
[Fig. 12] Fig. 2 is a sectional view showing a disadvantage of a known dye-sensitized solar cell.

### Description of Preferred Embodiments of the Invention

First, an ITO layer of an acid-resistant transparent electroconductive substrate according to the first aspect will be described.

The ITO layer according to the first aspect contains 30 percent by weight or more of SnO₂; hence, the SnO₂ content in the ITO layer is higher than that of known ITO layers. A SnO₂ content of less than 30 percent by weight does not lead to an ITO layer having a sufficient acid resistance. As the ITO layer contains a higher content of SnO₂, the acid resistance is enhanced. Excessive contents of SnO₂ however increase the resistance and make it difficult to form the layer by DC sputtering. Such an ITO layer has a high resistance and results in poor electroconductivity undesirably.

The SnO₂ content in the ITO layer is preferably 30 percent by weight or more, more preferably 30 to 80 percent by weight, and particularly preferably 35 to 70 percent by weight.

The transparent base on which the ITO layer is formed may be a glass plate, such as of silicate glass. Among others preferred are flexible transparent electroconductive substrates using flexible transparent bases, such as polymer films. Among polymer films used are polycarbonate, polymethyl methacrylate, polyvinyl chloride, polystyrene, and polyethylene terephthalate (PET), because these polymer films are superior in transparency and birefringence. The transparent polymer base generally has a thickness of about 75 µm to 2 mm. If a glass substrate is used, the thickness is generally about 0.5 to 5 mm.

Since the ITO layer containing at least 30 percent by weight of SnO₂ can be formed on the transparent base at low temperatures, the ITO layer is preferably formed by sputtering. For the formation of the ITO layer by sputtering, an ITO layer target containing at least 30 percent by weight of SnO₂ may be used, or reactive sputtering may be preformed in an oxygen atmosphere using a metal or alloy target.

Preferably, the ITO layer is formed to a thickness of about 100 to 1,000 nm.

The transparent electroconductive substrate according to the first aspect has a high acid resistance, and is accordingly suitably used in processes for forming a semiconductor layers on the ITO layer which include an acid treatment step.

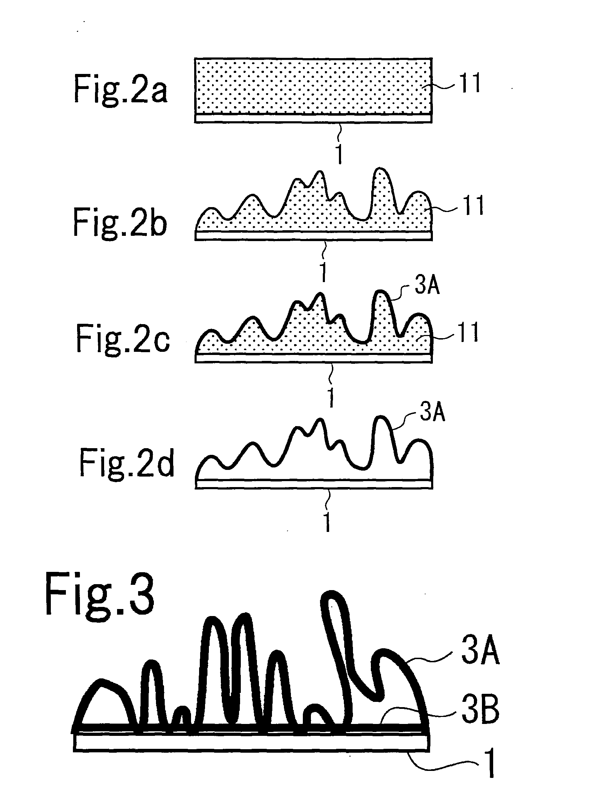

The following will describe an example of the process for forming a semiconductor layer on the ITO layer including an acid treatment step, with reference to Figs. 2a to 2d.

In the process, a substrate 1 has a transparent electrocoriductive layer (not shown in Figs. 2a to 2d for the sake of clarity) on the surface. First, a flat pre-replica layer is formed on the transparent electroconductive layer by a layer-by-layer self-assembly technique. The pre-replica layer is subjected to treatment for forming surface irregularities to form an irregular replica layer. Specifically, the pre-replica layer is defined by a flat layer-by-layer self-assembled film 11 prepared by the layer-by-layer self-assembly technique, as shown in Fig. 2a, and is then subjected to the treatment for forming surface irregularities to form the irregular replica layer, as shown in Fig. 2b.

The layer-by-layer self-assembly technique has been known. Specifically, the layer-by-layer self-assembly technique is a method for forming organic composite thin films and was released in 1992 by G. Decher et al. (Decher, G., Hong, J. D. and J. Schmit: Thin Solid Films, 210/211, p. 831 (1992)). In this method, organic composite thin films are formed by layer-by-layer electrostatic self-assembly. According to the basic method proposed by G. Decher et al., first, an aqueous solution of a positive electrolyte polymer (cationic polymer) and an aqueous solution of a negative electrolyte polymer (anionic polymer) are prepared in respective containers. Then, a substrate (material to be coated) to which an initial surface charge is applied is alternately dipped in the solutions in the containers, so that an ultra-thin multilayer organic composite film (layer-by-layer self-assembled film) is formed on the substrate. If, for example, a glass substrate is used as the material to be coated, the surface of the glass substrate is subjected to hydrophilic treatment to introduce the OH-group, and a negative charge is applied as the initial surface charge. The substrate whose surface is negatively charged is dipped in a positive electrolyte polymer aqueous solution. The positive electrolyte polymer is adsorbed to the surface of the substrate by Coulomb force at least until the surface charge is neutralized. Thus, an ultra-thin single layer is formed, and the surface of the resulting ultra-thin layer is positively charged. Subsequently, the resulting substrate is dipped in the negative electrolyte polymer aqueous solution. The negative electrolyte polymer is adsorbed by Coulomb force, and thus another ultra-thin single layer is formed. By alternately dipping the substrate in the two solutions in the containers, ultra-thin positive electrolyte polymer layers and ultra-thin negative electrolyte polymer layers are alternately deposited one on top of another to form a multilayer organic composite thin film.

In the process shown in Figs. 2a to 5, polyacrylamine hydrochlorides are preferably used as the positive electrolyte polymer. Other examples of the positive electrolyte polymer include polypyrrole, polyaniline, poly(p-phenylene) (+), poly(p-phenylene vinylene), and polyethylimine. A preferred negative electrolyte polymer is polyacrylic acid. Other examples of the negative electrolyte polymer include poly(p-phenylene) (-), polystyrene sulfonic acid, polythiophene-3-acetic acid, polyamic acid, and polymethacrylic acid.

The positive polymer and the negative polymer are dissolved separately to prepare their solutions having appropriate viscosities and placed in respective baths. The transparent electroconductive layer-coated substrate 1 is alternately dipped in the polymer solutions in the vessels, and thus a layer-by-layer self-assembled film is formed. Each layer of this film preferably has a thickness of about 0.1 to 0.4 µm, and the number of the layers is preferably 5 to 30, and particularly about 10 to 15.

For forming each layer to a predetermined thickness, the step of dipping the substrate in a bath, followed by drawing it up and rinsing with pure water may be repeated several times, for example, 2 to 10 times.

Acids used for giving surface irregularities to the pre-replica layer defined by the thus formed layer-by-layer self-assembled film include, but not limited to, hydrochloric acid, sulfuric acid, and nitric acid, and hydrochloric acid is preferably used. As for the concentration of the acid, the acid preferably has a pH of about 2.0 to 2.8. In a condition at room temperature, the substrate is preferably immersed in the acid for about 0.5 to 10 minutes.

The replica layer formed by the acid treatment may be vacuum-dried preferably at a temperature of 50 to 90°C if necessary, and then a semiconductor layer 3A is formed on the replica layer, as shown in Fig. 2c. The semiconductor layer is preferably formed of titanium oxide and its thickness is about 1 to 20 µm, particularly preferably about 5 to 15 µm.

The semiconductor layer can be formed by a variety of processes including wet techniques, such as chemical solution deposition, and dry techniques, such as reactive sputtering.

The resulting semiconductor layer may be hydrothermally treated (for example, at 100 to 150°C for 5 to 15 hours) or fired (for example, at 500 to 700°C for 0.5 to 2 hours). The firing is performed preferably in an atmosphere of air or oxygen gas. The crystal grain size of titanium oxide is reduced by the hydrothermal treatment or firing.

After the formation of the semiconductor layer of, for example, titanium oxide, the replica layer is removed as shown in Fig. 2d if it remains. If the above-mentioned firing is performed in an oxidizing atmosphere, such as in air, the replica layer is removed by this firing.

The removal of the replica layer is preferably performed by alkaline treatment for dissolving the polymer, or by firing at a temperature of 500 to 700°C. Preferred alkalis include sodium hydroxide and potassium hydroxide. For example, by immersion in an alkali with a pH of 10 to 12 for 6 to 12 hours, the layer-by-layer self-assembled film can be removed.

The semiconductor layer with rich irregularities and a high specific surface is thus formed over the transparent electroconductive layer on the substrate. The above-described process can produce a semiconductor layer with a surface roughness RMS of about 10 to 100 nm and a large surface area.

In the process shown in Figs. 2a to 2d, a single irregular semiconductor layer 3A is formed over the transparent electroconductive layer (not shown). Alternatively, a flat semiconductor layer 3B may be formed on the transparent electroconductive layer, as shown in Fig. 3, by the above-mentioned wet technique or dry technique before forming the irregular semiconductor layer 3A by the above-described process.

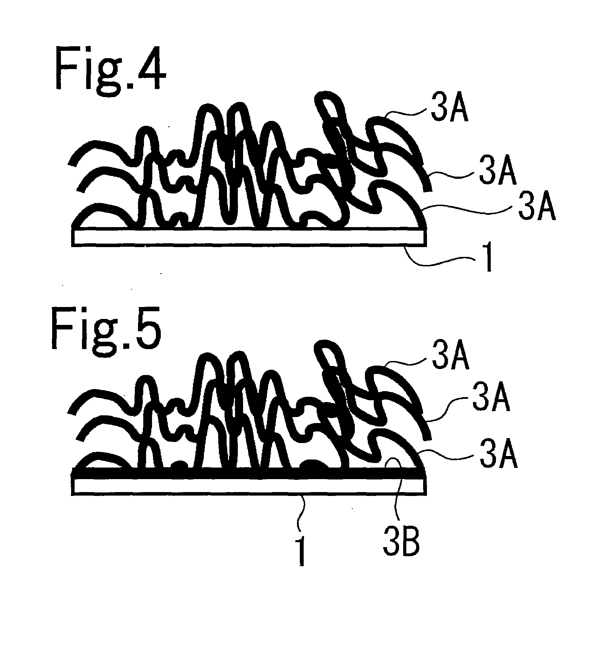

A plurality of semiconductor layers 3A may be formed, as shown in Fig. 4, by repeating a sequence including, this order, the steps of forming the layer-by-layer self-assembled film, forming irregularities, forming the semiconductor layer, and removing the replica layer removal.

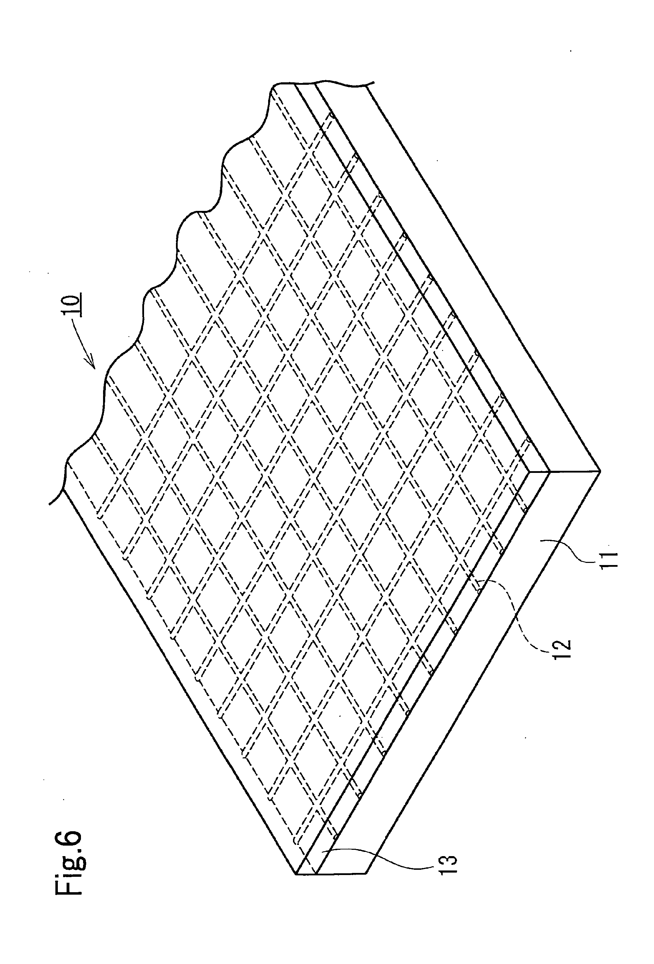

A flat semiconductor layer 3B may be formed on the transparent electroconductive layer (not shown) as shown in Fig. 5 before forming the plurality of semiconductor layers 3A as shown in Fig. 4.

A dye-sensitized solar cell according to the third aspect includes a dye-sensitized semiconductor electrode according to the second aspect having the semiconductor layer formed preferably by the above-described process. The other components of this dye-sensitized solar cell are the same as those of the known dye-sensitized solar cell shown in Fig. 1.

Metal oxide semiconductors for the spectral sensitizing dye-adsorbed metal oxide semiconductor layer 3 of the dye-sensitized semiconductor electrode 4 include known semiconductors, such as titanium oxide, zinc oxide, tungsten oxide, antimony oxide, niobium oxide, tungsten oxide, indium oxide, barium titanate, strontium titanate, and cadmium sulfide. These semiconductors may be used singly or in combination. Among these particularly preferred is titanium oxide, from the viewpoint of stability and safety. Varieties of titanium oxide include anatase-type titanium oxide, rutile-type titanium oxide, amorphous titanium oxide, metatitanic acid, and orthotitanic acid, and besides, titanium hydroxide and hydrous titanium oxide are included. In particularly, anatase-type titanium oxide is preferably used. Preferably, the metal oxide semiconductor layer has a fine crystalline structure.

The organic dye (spectral sensitizing dye) adsorbed to the oxide semiconductor layer exhibits absorption in the visible region and/or the infrared region, and various types of metal complexes and organic dyes can be used singly or in combination. Preferably, the molecule of the spectral sensitizing dye has a functional group, such as carboxyl, hydroxyalkyl, hydroxyl, sulfone, or carboxyalkyl. Such dyes can be quickly adsorbed to semiconductors. Preferably, the spectral sensitizing dye is a metal complex because of its high spectral sensitizing effect and durability. Examples of the metal complexes include metal phthalocyanines, such as copper phthalocyanine and titanyl phthalocyanine, chlorophyll, hemin, and complexes of ruthenium, osmium, iron and zinc disclosed in Japanese Unexamined Patent Application Publication No. 1-220380 and PCT Japanese Translation Patent Publication No. 5-504023. Examples of the organic dye include metal-free phthalocyanine, cyanine dyes, merocyanine dyes, xanthene dyes, and triphenylmethane dyes. Among cyanine dyes are, for example, NK1194 and NK3422 (each produced by Nippon Kanko Shikiso Kenkyusho). Among merocyanine dyes are, for example, NK2426 and NK2501 (each produced by Nippon Kanko Shikiso Kenkyusho). Among xanthene dyes are, for example, uranine, eosine, Rose Bengal, rhodamine B, and dibromfluorescein. Among triphenylmethane dyes are, for example, malachite green and crystal violet.

In order to adsorb the organic dye (spectral sensitizing dye) to the semiconductor layer, the oxide semiconductor layer on the substrate can be immersed in an organic dye solution prepared by dissolving the organic dye in an organic solvent at room temperature or under heating. Any solvent can be used for the solution, as long as it can dissolve the spectral sensitizing dye. Examples of the solvent include water, alcohols, toluene, and dimethylformamide.

The opposing electrode 5 needs to be electroconductive, and can be made of any electroconductive material. The electroconductive material preferably has a catalytic action that induces the oxidizing redox ions in the electrolyte, such as I₃⁻ ions, to reduce at a sufficient rate. Such electroconductive materials include platinum electrodes, platinum-plated or platinum-vapor-deposited electroconductive materials, rhodium metal, ruthenium metal, ruthenium oxide, carbon, cobalt, nickel, and chromium.

The dye-sensitized semiconductor electrode 4 is prepared by forming the ITO layer 2 containing 30 percent by weight or more of SnO₂ as the transparent electroconductive layer 2 on the substrate (transparent base) 1 preferably by sputtering, then forming the semiconductor layer 3 on the ITO layer in the above-described manner, and adsorbing the dye in the above-described manner.

The semiconductor electrode 4 including the dye-adsorbed semiconductor layer is opposed to the opposing electrode 5 being a substrate, such as a glass plate or a polymer film, coated with another transparent electroconductive layer. The space between these electrodes are filled with an electrolyte 6 and sealed with a sealant. The dye-sensitized solar cell is thus completed.

The first to third aspects will be further described in detail with reference to the following example and comparative example.

Example 1
An ITO target (SnO₂ content: 36 percent by weight) was set to a magnetron DC sputtering apparatus, and a 188 µm thick PET film was placed in a vacuum chamber. The vacuum chamber was evacuated to 5 × 10⁻⁴ Pa with a turbo molecular pump, and subsequently Ar gas and O₂ gas were introduced as a gas mixture at flow rates of 197 sccm and 3 sccm respectively so as to adjust the pressure in the chamber to 0.5 Pa. Then, a power of 4 kW was applied to the ITO target, and thus an ITO layer, or transparent electroconductive film, was formed to a thickness of about 300 nm on the PET film.

The transparent electroconductive film was immersed in a hydrochloric acid aqueous solution with a pH of 2.0, and the surface resistance with time was measured to evaluate the acid resistance. The results are shown in Table 1.

Comparative Example 1
A transparent electroconductive film was prepared in the same manner as in Example 1, except that an ITO target having a SnO₂ content of 10 percent by weight was used. The acid resistance of the resulting film was evaluated in the same manner. The results are shown in Table 1.

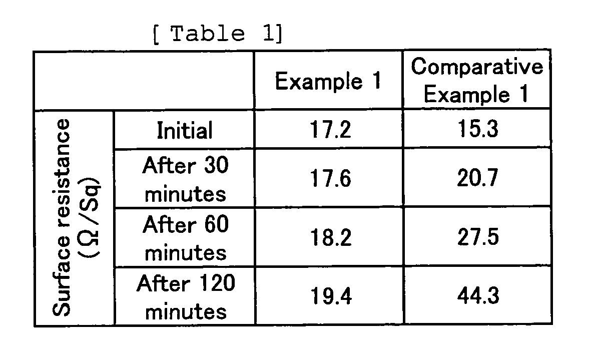

Table 1 shows that Comparative Example 1 using the ITO layer with a SnO₂ content of 10 percent by weight increased the resistance after 120 minutes to three times the initial resistance while Example 1 using the ITO layer with a SnO₂ content of 36 percent by weight increased the resistance after 120 minutes by 15% or less with respect to the initial resistance. Example 1 exhibited the effect of greatly enhancing the acid resistance.

The fourth to sixth aspects will now be described in detail.

In the fourth to sixth aspects, the transparent base may be a glass plate, such as silicate glass, and is preferably a flexible transparent electroconductive substrate, such as a flexible polymer film. Among polymer films used are, for example, polycarbonate, polymethyl methacrylate, polyvinyl chloride, polystyrene, and polyethylene terephthalate (PET) because these polymer films are superior in transparency and birefringence. The thickness of the polymer film is generally about 75 µm to 2 mm. If a glass substrate is used, the thickness is generally about 0.5 to 5 mm.

The transparent electroconductive layer formed on the transparent base can be made of a transparent electroconductive material selected from the group consisting of ITO, InTiO, IZO (indium zinc oxide), GZO (gallium-doped zinc oxide), and AZO (aluminum-doped zinc oxide). Preferably, the transparent electroconductive layer is made of ITO. The transparent electroconductive layer may be a composite constituted of layers or a mixture of at least two types of transparent electroconductive materials.

The transparent electroconductive layer, such as an ITO layer, is generally formed to a thickness of about 100 to 1000 nm.

The titanium oxide thin layer formed on the transparent electroconductive layer is expressed by TiOx (x = 1.7 to 2.0, preferably 1.8 to 2.0). A titanium oxide thin layer with an excessively small thickness cannot sufficiently enhance the acid resistance, in spite of its presence. An excessively large thickness increases costs, and leads to a degraded flexibility if a film is used as the base. Accordingly, the thickness of the titanium oxide thin layer is preferably 1 to 500 nm, and particularly preferably 10 to 300 nm.

Since the transparent electroconductive layer and the titanium oxide thin layer can be formed at low temperatures, they are preferably formed by sputtering. The formation of the transparent electroconductive layer and the titanium oxide thin layer may be performed by sputtering using a metal oxide target, or by reactive sputtering using a metal or alloy target in an oxygen atmosphere. The sputtering for forming the transparent electroconductive layer and the titanium oxide thin layer can be continuously performed, and is thus efficient.

The transparent electroconductive substrate of the fourth aspect has a high acid resistance, and it can be subjected to acid treatment. The acid treatment can be suitably applied to a process for forming an additional semiconductor layer over the titanium oxide thin layer on the transparent electroconductive layer, such as an ITO layer.

A preferred process for forming the semiconductor layer over the transparent electroconductive layer, such as an ITO layer, including the acid treatment step is conducted in the same manner as described above with reference to Figs. 2a to 2d and 3 to 5, and is applied to the fourth to sixth aspect.

A dye-sensitized solar cell according to the sixth aspect includes a dye-sensitized semiconductor electrode according to the fifth aspect having a semiconductor layer formed preferably by this process. The other components in the structure are the same as those of the known dye-sensitized solar cell as shown in Fig. 1.

The metal oxide semiconductor of the spectral sensitizing dye-adsorbed metal oxide semiconductor layer 3 of the dye-sensitized semiconductor electrode 4 can be according to the above-described preferred embodiment of the first to third aspects.

The organic dye (spectral sensitizing dye) adsorbed to the oxide semiconductor layer can be according to the preferred embodiment of the first to third aspects.

The method for adsorbing the organic dye (spectral sensitizing dye) to the semiconductor layer can be according to the above-described preferred embodiment of the first to third aspects.

The opposing electrode 5 can be according to the above-described preferred embodiment of the first to third aspects.

The dye-sensitized semiconductor electrode 4 is prepared by forming the transparent electroconductive layer 2 of, for example, ITO and the titanium oxide thin layer on the substrate (transparent base) 1 preferably by sputtering, then forming the semiconductor layer 3 over the titanium oxide thin layer in the above-described manner, and adsorbing the dye in the above-described manner.

The semiconductor electrode 4 including the dye-adsorbed semiconductor layer is opposed to is opposed to the opposing electrode 5 being a substrate, such as that of a glass plate or a polymer film, coated with another transparent electroconductive layer. The space between these electrodes are filled with an electrolyte 6 and sealed with a sealant. The dye-sensitized solar cell is thus completed.

The fourth to sixth aspects will be further described in detail with reference to the following example and comparative example.

Example 2
An ITO target (SnO₂ content: 10 percent by weight) and a Ti target were set to a magnetron DC sputtering apparatus, and a 188 µm thick PET film was placed in a vacuum chamber. The vacuum chamber was evacuated to 5 × 10⁻⁴ Pa with a turbo molecular pump, and subsequently Ar gas and O₂ gas were introduced as a gas mixture at flow rates of 197 sccm and 3 sccm respectively so as to adjust the pressure in the chamber to 0.5 Pa. Then, a power of 4 kW was applied to the ITO target, and thus an ITO layer was formed to a thickness of about 300 nm on the PET film. Then, after completely purging the chamber with Ar gas, Ar gas and O₂ gas as the gas mixture were introduced again to the chamber at flow rates of 170 sccm and 30 sccm respectively so as to adjust the pressure to 0.5 Pa. Then, a power of 6 kW was applied to the Ti target and a TiO₂ thin layer was formed to a thickness of about 30 nm on the ITO layer by reactive sputtering, thus forming the transparent electroconductive film.

The resulting transparent electroconductive film was immersed in a hydrochloric acid aqueous solution with a pH of 2.0, and the surface resistance with time was measured to evaluate the acid resistance. The results are shown in Table 2.

Comparative Example 2
A transparent electroconductive film was prepared in the same manner as in Example 2, except that the titanium oxide thin layer was not formed. The acid resistance of the resulting film was evaluated in the same manner. The results are shown in Table 2.

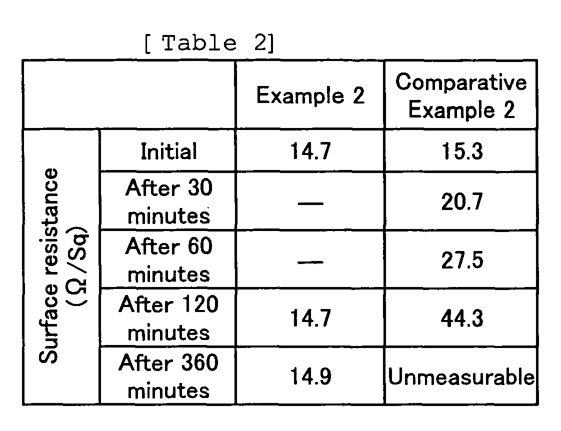

Table 2 shows that Comparative Example 2 using only the ITO layer increased the resistance after 120 minutes to three times the initial resistance while Example 2 using the ITO layer coated with the titanium oxide thin layer hardly change the resistance even after 360 minutes. Example 2 exhibited the effect of greatly enhancing the acid resistance.

The seventh to ninth aspects will now be described.

A transparent electroconductive body according to the seventh aspect includes a transparent electroconductive layer formed on a base, and a meshed electrical conductor made of a metal or ally having a lower resistance than the transparent electroconductive layer between the base and the transparent electroconductive layer. The meshed electrical conductor is formed through the first step of forming dots of a material soluble in a solvent on the surface of the base, the second step of forming an electroconductive material layer of an electroconductive material insoluble in the solvent over the surface of the base, and the third step of removing the dots and the electroconductive material layer in the regions overlying the dots by bringing the surface of the base into contact with the solvent.

The meshed electrical conductor (hereinafter may be referred to as "auxiliary electrode") of a metal or alloy having a lower resistance than the transparent electroconductive layer, provided between the base and the transparent electroconductive layer can reduce the resistance of the electrode. The auxiliary electrode is protected by the transparent electroconductive layer, so that it does not corroded by the electrolyte.

Since the meshed electrical conductor serving as the auxiliary electrode is formed through the first step of forming dots of a material soluble in a solvent on the surface of the base, the second step of subsequently forming an electroconductive material layer of an electroconductive material insoluble in the solvent over the surface of the base, and then the third step of removing the dots and the electroconductive material layer in the regions overlying the dots by bringing the surface of the base into contact with the solvent, the meshed electrical conductor has a high light transmittance and conductivity, and its effective production can be easily made at low temperatures. Specifically, the dots can be printed or formed using a low-viscosity material as the material soluble in the solvent. Accordingly, fine printing can be performed such that the intervals between the dots can be significantly reduced. Since the thin regions between the dots is intended for the meshed electrical conductor, which is to be defined by the residue of the electroconductive material, the seventh aspect can provide an extremely fine electroconductive mesh pattern with high precision. By reducing the width of the thin regions, the opening ratio of the mesh can be increased.

The base of the transparent electroconductive body according to the seventh aspect is preferably made of a transparent electroconductive polymer film.

Preferably, the transparent electroconductive layer is formed by sputtering, and particularly preferably by reactive sputtering. Sputtering can provide a favorable low-resistance layer even on a thermally unstable substrate, such as a transparent resin film. Preferably, wet-plating is performed on the surface of the meshed electrical conductor to further reduce the resistance.

The transparent electroconductive body according to the seventh aspect is suitable for the dye-sensitized solar cell electrode according to the eighth aspect, and particularly for the opposing electrode of the dye-sensitized solar cell according to the ninth aspect. The opposing electrode includes a platinum thin layer overlying the transparent electroconductive layer. The platinum thin layer is preferably formed by sputtering as well.

Preferably, the opposing electrode has spacers made of an insulative material at least in the outer region of the surface that is to be opposed to a dye-sensitized semiconductor electrode with an electrolyte in between. The spacers prevent the opposing electrode from coming into contact with the semiconductor electrode.

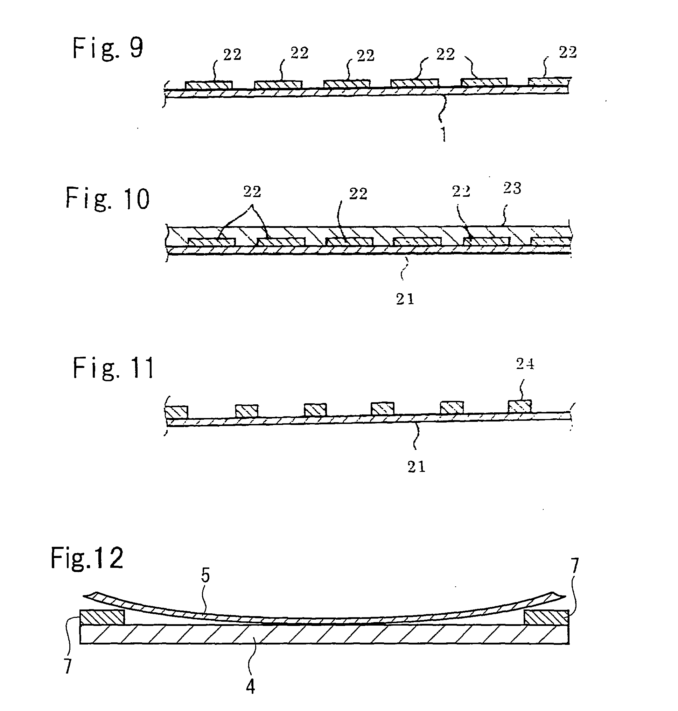

In the dye-sensitized solar cell, the unit defined by the semiconductor electrode 4 and the opposing electrode 5 with the electrolyte in between has variations in the distance between the opposing electrode 5 and the semiconductor electrode 4 resulting from a warp or other deformation of the opposing electrode 5, as shown in Fig. 12. Consequently, the opposing electrode 5 may come into contact with the semiconductor electrode 4 to crate a short circuit in some cases. If the dye-sensitized solar cell has a large area, it becomes difficult for the spacers 7 to maintain the distance between the electrodes, and accordingly the deformation of the opposing electrode 5 becomes particularly large. In addition, thin and lightweight dye-sensitized solar cells have recently been desired, and accordingly base films coated with an electroconductive layer are being increasingly used as the opposing electrode 5. In such film-type opposing electrodes, it is difficult for the spaces 7 to maintain the distance between the electrodes. The film-type opposing electrodes are liable to be warped or deformed, and the degree of the deformation can be large. The variations in distance between the electrodes lead to variations in photoelectric conversion efficiency of the dye-sensitized solar cell, and a large variation may cause a short circuit and result in a failure in electric power generation.

By providing additional spacers made of an insulative material for preventing the contact of the opposing electrode with the semiconductor electrode in the outer region of the surface that is to be opposed to the semiconductor electrode, the opposing electrode can be prevented from deforming, and a constant distance can be maintained between the opposing electrode and the semiconductor electrode.

Also, the distance between the electrodes can be finely adjusted by varying the height of the spacers, so that the photoelectric conversion efficiency can be enhanced.

Since the spacers are provided on the opposing electrode, other spacers need not to be separately provided in the fabrication of the solar cell. Thus, the number of parts can be reduced and the fabrication of the solar cell is facilitated.

The spacers are preferably formed in dots (and are hereinafter referred to as dotted spacers). The spacers are preferably formed of a transparent insulative material.

The dye-sensitized solar cell according to the ninth aspect includes a dye-sensitized semiconductor electrode, an opposing electrode opposing the dye-sensitized semiconductor electrode, an electrolyte disposed between the dye-sensitized semiconductor electrode and the opposing electrode. This opposing electrode is the electrode of the eighth aspect, which has a low resistance and a high durability. Accordingly, the opposing electrode contributes to electric powder generation with a high photoelectric conversion efficiency.

According to the seventh to ninth aspects, the transparent electroconductive body and dye-sensitized solar cell electrode that have low resistances and high durabilities can provide a dye-sensitized solar cell having a high photoelectric conversion efficiency.

Embodiments of the transparent electroconductive body, the dye-sensitized solar cell electrode and the dye-sensitized solar cell according to the seventh to ninth aspects will now be described in detail with reference to drawings. In following description, the transparent electroconductive body according to the seventh aspect is used as a dye-sensitized solar cell electrode. However, the transparent electroconductive body of the seventh aspect is not limited to the use as the dye-sensitized solar cell electrode, and may be used in various applications using electrodes that have corrosion-resistant surfaces, transparency, small thickness, low weight, and flexibility.

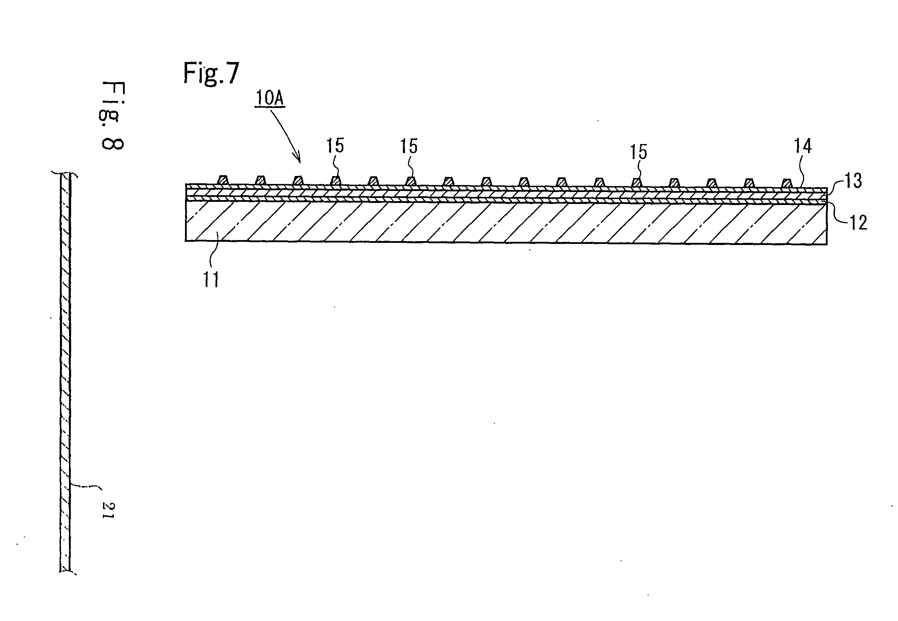

Fig. 6 is a perspective view of the dye-sensitized solar cell electrode according to an embodiment of the eighth aspect, and Fig. 7 is a sectional view according to another embodiment.

The dye-sensitized solar cell electrode 10 shown in Fig. 6 includes a meshed metal or alloy auxiliary electrode 12 on a base film 11, and a transparent electroconductive layer 13 over the meshed electrode 12. The opposing electrode 10A shown in Fig. 7 used for the dye-sensitized solar cell includes an auxiliary electrode 12 on a base film 11, a transparent electroconductive layer 13 over the auxiliary electrode 12, a platinum (Pt) thin layer 14 over the transparent electroconductive layer 13, and spacers 15 formed of an insulative material in dots on the pt thin layer 14.

Preferably, the base film 11 is a polymer film, such as polycarbonate, polymethyl methacrylate, polyvinyl chloride, polystyrene, or polyethylene terephthalate, because these polymer films are superior in transparency and birefringence. The thickness of the base film is generally about 12 µm to 2 mm.

The auxiliary electrode 12 can be made of any metal or alloy having a lower resistance than transparent electroconductive layer 13 without particular limitation. In general, the auxiliary electrode 12 is made of Ag, a Ag alloy (Ag/Pd, Ag/Nd, Ag/Au, etc.), Cu, a Cu alloy, Al, an Al alloy, Ni, or a Cr alloy. These metal and alloy may be used singly or in combination.

Although the auxiliary electrode 12 may be formed to such a small thickness as does not degrade the transparency, such a thin-layer auxiliary electrode cannot sufficiently reduce the resistance. Accordingly, the auxiliary electrode is formed in mesh, as shown in Fig. 6. The line form of the meshed auxiliary electrode 12 and the opening ratio of the mesh are not particularly limited. However, an excessively small line width and an excessively high opening ratio cannot sufficiently reduce the resistance. In contrast, an excessively large line width and an excessively low opening ratio degrade the transparency of the electrode. Preferably, the line width of the meshed auxiliary electrode 12 is 10 to 1000 µm and the opening ratio (area ratio of the openings to the electrode) is 80% or more.

A process for forming the auxiliary electrode 12 of the meshed electrical conductor will now be described with reference to Figs. 8 to 11. Figs. 8 to 11 are schematic sectional views showing the procedure of a process for forming the meshed electrical conductor according to the seventh aspect.

First, dots 22 are printed on a polymer film 21 using a material soluble in a solvent, such as water, as shown in Figs. 8 and 9. Turning then to Fig. 10, an electroconductive material layer 23 is formed over the entire surfaces of the dots 22 and the polymer film 21 exposed between the dots 22. Then, the film 21 is washed with the solvent, such as water. In this step, the washing may be combined with means for promoting dissolution, such as exposure to ultrasonic waves or rubbing with, for example, a brush or a sponge, if necessary.

Consequently, the soluble dots 22 are dissolved from the film 21, and the electroconductive material in the regions overlying the dots 22 is also removed, as shown in Fig. 11. Thus, an electroconductive mesh pattern 24 defined by the electroconductive material in the regions between the dots is left on the film 21. The electroconductive mesh pattern 24 occupies the regions between the dots 22, and hence in a mesh form.

Accordingly, by forming the dots 22 at small intervals, the mesh of the resulting electroconductive mesh pattern 24 has a small line width. Also, by increasing the area of the dots 22, the electroconductive mesh pattern 24 has a high opening ratio. The printing material soluble in, for example, water for forming the dots 22 does not need particles dispersed and can have a low viscosity. By use of the low-viscosity printing material, dots can be printed so as to form a fine dot pattern.

Incidentally, the step shown in Fig. 11 may be followed by finish washing (rinsing) and drying, if necessary.

Preferably, the dots 22 on the polymer film 21 are formed by printing. The printing material is a solution of a material soluble in the solvent for removing the dots 22. While the dots 22 may be dissolved in an organic solvent, the solvent is preferably water from the viewpoint of environmental impact. The water may be normal water or an aqueous solution containing an acid, an alkali, or a surfactant. The printing material may contain a pigment or dye to facilitate the checkup of the finished state after printing.

In the connection with the use of water as the solvent, the dots 22 are preferably formed of a watersoluble polymer. For example, polyvinyl alcohol is suitable.

The dots 22 are printed in such a manner that the regions between the dots where the film is exposed form a mesh. Preferably, the dots 22 are printed in such a manner that the line width of the regions where the film is exposed is 30 µm or less. Preferred printing techniques include gravure printing, screen printing, ink jet printing, and electrostatic printing, and gravure printing is suitable for forming thinner lines.

The dots 22 can be in any shape, such as circles, ellipses, and polygons. Among these preferred are polygons and particularly square. The thickness of the printed dots 22 is, but not particularly limited to, about 0.1 to 5 µm.

The dots 22 are preferably dried after being printed. Subsequently, an electroconductive material layer 23 is formed of the above-described material for forming the auxiliary electrode.

The electroconductive material layer 23 has preferably has a thickness of about 0.1 to 100 µm. If the thickness is excessively small, the meshed electrical conductor cannot sufficiently reduce the resistance, in spite of its presence. An excessively large thickness affects the thickness of the resulting dye-sensitized solar cell electrode and accordingly reduces the optical transparency.

The electroconductive material layer 23 can be formed by, for example, gas-phase plating, such as sputtering, ion plating, vacuum vapor deposition or chemical vapor deposition, liquid-phase plating (electrolytic plating, electroless plating, etc.), printing, or coating. Preferably, gas-phase plating in a broad sense (sputtering, ion plating, vacuum vapor deposition, chemical vapor deposition) or liquid phase plating is employed.

After the formation of the electroconductive material layer 23, the dots 22 are removed with a solvent, preferably water, as described above, followed by drying if necessary. The meshed electrical conductor serving as the auxiliary electrode is thus completed.

The meshed electrical conductor may be further subjected to wet plating to form a wet-plating layer so that the resistance is further reduced.

Preferably, the transparent electroconductive layer 13 over the thus formed auxiliary electrode 12 is made of ITO, FTO, ATO, SnO₂, or the like, and generally has a thickness of about 100 to 1000 nm. A SnO₂-based transparent electroconductive layer is resistant to corrosion by I₂ and is therefore particularly preferable.

The transparent electroconductive layer 13 is preferably formed by sputtering, and particularly preferably by reactive sputtering in an atmosphere of oxygen gas. Sputtering can continuously form the auxiliary electrode 12 and the transparent electroconductive layer 13 at a low temperature up to the heat-resistant temperature of the base film 11, and is thus efficient.

The electrode 10 shown in Fig. 10 may be provided with a dye-adsorbed semiconductor layer over the transparent electroconductive layer to serve as the semiconductor electrode of a dye-sensitized solar cell. Alternatively, the electrode 10 may be further provided with a Pt thin layer 14, as shown in Fig. 7, to form the opposing electrode of a dye-sensitized solar cell.

In the opposing electrode 10A shown in Fig. 7, the Pt thin layer 14 overlying the transparent electroconductive layer 13 generally has a thickness of about 0.1 to 10 nm so as to ensure transparency. As an alternative to the Pt thin layer, a carbon layer may be formed.

The Pt thin layer 14 can also be formed by sputtering, so that the transparent electroconductive layer 13 and the Pt thin layer 14 are continuously formed at low temperatures. Sputtering is thus efficient.

The insulative dotted spacers 15 of the opposing electrode 10A shown in Fig. 7 are preferably made of a transparent insulative material. Transparent insulative materials for forming the transparent dotted spacers 15 include resins, such as acrylic, polyester, and polyurethane, and one or at least two of these resins may be used.

The insulative dotted spacers 15 in the dye-sensitized solar cell have a height substantially equal to the distance that must be held between the semiconductor electrode and the opposing electrode.

The shape of the insulative dotted spacers 15 is not particularly limited, and may be in a frustum of a cone or pyramid, a cylinder, or a prism.

If the percentage of the insulative dotted spacers 15 is excessively low, the dotted spacers 15 cannot sufficiently prevent the deformation of the opposing electrode or hold the distance between the electrodes. If the percentage is excessively high, the effective area of the opposing electrode 10A is reduced, and consequently the photoelectric conversion efficiency is reduced. Accordingly, it is preferable that the insulative dotted spacers are formed such that the ratio of the total bottom area (area projected on the surface of the electrode) of the dotted spacers 15 to the area of the opposing electrode 10A becomes 1% or less, although the ratio may depend on ease of deformation that depends on the type of the base film 11 used in the opposing electrode 10A or on the area of the opposing electrode 10A.

The dotted spacers 15 do not necessarily have the same height, some of the dotted spacers 15 can have different heights. Also, the shape or area (area projected on the surface of the electrode) of the dotted spacers 15 is not necessarily the same, and some of the dots may have different shapes or areas.

The process for forming the dotted spacers 15 of the transparent insulative material is performed on the base film 11 having the auxiliary electrode 12, the transparent electroconductive layer 13 and the Pt thin layer 14 by, for example, screen printing.

In the present invention, any type of spacers can be provided to the opposing electrode 10A, as long as they can prevent the opposing electrode from coming into contact with the semiconductor electrode without largely reducing the electroconductivity of the opposing electrode. The spacers may be in dots, as shown in Fig. 2, or in (straight or curved) lines or a grid, or in combination of these forms. The percentage (area ratio) of these spacers is preferably in the above-described range.

The spacers, such as the dotted spacers 15, may be formed over the entire surface of the opposing electrode, or only in the outer region. Specifically, the spacers, such as the dotted spacers 15, may be formed only in a region other than the outer region and the known spacers 7 as shown in Fig. 1 may be formed in the outer region.

If spacers similar to the known spacers are provided in the outer region, other spacers provided in the region other than the outer region do not necessarily have the same height as the distance that must be held between the electrodes. Even if their height is slightly smaller than the distance, the contact of the electrodes can be sufficiently prevented. If the spacers according to the present invention are provided over the entire surface of the opposing electrode, the known spacers in the outer region are not necessary and the solar cell can be easily fabricated.

The dye-sensitized solar cell according to the ninth aspect can be fabricated by a conventional manner using the electrodes of the present invention. In particular, the use of the opposing electrode shown in Fig. 7 eliminates the use of separately prepared spacers, as described above, and thus facilitates the fabrication and leads to superior workability.

The seventh to ninth aspects are particularly suitably applied to, but not limited to, film-type transparent electroconductive films using base films that are easy to deform, and can be applied to transparent electroconductive substrates using glass substrates.

## Claims

1. An acid-resistant transparent electroconductive substrate comprising: a transparent base; and an ITO layer formed on the transparent base, the ITO layer containing at least 30 percent by weight of tin oxide.

2. The acid-resistant transparent electroconductive substrate according to Claim 1, wherein the transparent base is a transparent electroconductive polymer film.

3. The acid-resistant transparent electroconductive substrate according to Claim 1, wherein the ITO layer is formed by sputtering.

4. The acid-resistant transparent electroconductive substrate according to Claim 1, wherein the acid-resistant transparent electroconductive substrate is used as a transparent electroconductive substrate for an electrode of a dye-sensitized solar cell.

5. A dye-sensitized solar cell electrode comprising: the transparent electroconductive substrate as set forth in Claim 1; and a dye-adsorbed semiconductor layer formed on the ITO layer of the transparent electroconductive substrate.

6. A dye-sensitized solar cell comprising: a dye-sensitized semiconductor electrode; an opposing electrode opposing the dye-sensitized semiconductor electrode; an electrolyte disposed between the dye-sensitized semiconductor electrode and the opposing electrode, wherein the dye-sensitized semiconductor electrode is the dye-sensitized solar cell electrode as set forth in Claim 5.

7. An acid-resistant transparent electroconductive substrate comprising: a transparent base; and a transparent electroconductive layer formed on the transparent base, wherein a titanium oxide thin layer is formed on the transparent electroconductive layer.

8. The acid-resistant transparent electroconductive substrate according to Claim 7, wherein the transparent electroconductive layer is made of a material selected from the group consisting of ITO, InTiO, IZO, GZO, and AZO.

9. The acid-resistant transparent electroconductive substrate according to Claim 7, wherein the titanium oxide thin layer has a thickness of 1 to 500 nm.

10. The acid-resistant transparent electroconductive substrate according to Claim 7, wherein the transparent base is a transparent electroconductive polymer film.

11. The acid-resistant transparent electroconductive substrate according to Claim 7, wherein the transparent electroconductive layer and the titanium oxide thin layer are formed by sputtering.

12. The acid-resistant transparent electroconductive substrate according to Claim 7, wherein the acid-resistant transparent electroconductive substrate is used as a transparent electroconductive substrate for an electrode of a dye-sensitized solar cell.

13. A dye-sensitized solar cell electrode comprising: the transparent electroconductive substrate as set forth in claim 7; and a dye-adsorbed semiconductor layer formed on the titanium oxide thin layer of the transparent electroconductive substrate.

14. A dye-sensitized solar cell comprising: a dye-sensitized semiconductor electrode; an opposing electrode opposing the dye-sensitized semiconductor electrode; a electrolyte disposed between the dye-sensitized semiconductor electrode and the opposing electrode, wherein the dye-sensitized semiconductor electrode is the dye-sensitized solar cell electrode as set forth in Claim 13.

15. A transparent electroconductive body comprising: a base; a transparent electroconductive layer overlying the base; and a meshed electrical conductor disposed between the base and the transparent electroconductive layer, the electrical conductor being made of a metal or alloy having a lower resistance than the transparent electroconductive layer,
wherein the meshed electrical conductor is formed through:
the first step of forming dots of a material soluble in a solvent on the surface of the base;
the second step of forming an electroconductive material layer of an electroconductive material insoluble in the solvent over the surface of the base; and
the third step of removing the dots and the electroconductive material layer in the regions overlying the dots by bringing the surface of the base into contact with the solvent.

16. The transparent electroconductive body according to Claim 15, wherein the base is made of a polymer film.

17. The transparent electroconductive body according to Claim 15, wherein the meshed electrical conductor is further treated by wet plating.

18. The transparent electroconductive body according to Claim 15, wherein the transparent electroconductive layer is formed by sputtering.

19. The transparent electroconductive body according to Claim 18, wherein the transparent electroconductive layer is formed by reactive sputtering.

20. The transparent electroconductive body according to Claim 15, further comprising a platinum thin layer on the transparent electroconductive layer.

21. The transparent electroconductive body according to Claim 20, wherein the platinum thin layer is formed by sputtering.

22. A dye-sensitized solar cell electrode comprising the transparent electroconductive body as set forth in Claim 15.

23. The dye-sensitized solar cell electrode according to Claim 22, wherein the dye-sensitized solar cell electrode is used as an opposing electrode that is opposed to a dye-sensitized semiconductor electrode with an electrolyte therebetween.

24. The dye-sensitized solar cell electrode according to Claim 23, further comprising spacers made of an insulative material for preventing contact with the semiconductor electrode, the spacers being provided at least in the outer region of the surface of the dye-sensitized solar cell electrode that is to be opposed to the semiconductor electrode.

25. The dye-sensitized solar cell electrode according to Claim 24, wherein the spacers are in dots.

26. The dye-sensitized solar cell electrode according to Claim 24, wherein the spacers are made of a transparent insulative material.

27. A dye-sensitized solar cell comprising: a dye-sensitized semiconductor electrode; an opposing electrode opposing the dye-sensitized semiconductor electrode; an electrolyte disposed between the dye-sensitized semiconductor electrode and the opposing electrode, wherein the opposing electrode is the electrode as set forth in Claim 22.
